Europäisches Patentamt

European Patent Office

Office européen des brevets

(19)

(11) Veröffentlichungsnummer: **0 000 180**
**B1**

(12) # EUROPÄISCHE PATENTSCHRIFT

(21) Anmeldenummer: 78100214.2

(22) Anmeldetag: 22.06.78

(51) Int. Cl.³: **H 01 L 27/10,**
**H 01 L 21/82,**
**H 01 L 21/265,**
**H 01 L 27/06**

(54) Halbleiter-Zellenstruktur für eine Eimerkettenschaltung sowie Verfahren zur Herstellung derselben

(30) Priorität: **24.06.77 US 809876**

(43) Veröffentlichungstag der Anmeldung:
**10.01.79 Patentblatt 79/01**

(45) Bekanntmachung des Hinweises auf die Patenterteilung:
**10.12.80 Patentblatt 80/25**

(84) Benannte Vertragsstaaten:
**DE FR GB**

(56) Entgegenhaltungen:
**DE - A - 2 508 833**
**FR - A - 2 161 003**
**FR - A - 2 197 207**
**US - A - 3 959 025**
**IEEE TRANSACTIONS ON ELECTRON DEVICES**
**BAND 23, Oktober 1976,**
**New York**
**C. G. SODINI et al "Enhaçed capacitor**
**for one-transistor memory cell",**
**Seiten 1187-1189**

(73) Patentinhaber: **International Business Machines**
**Corporation**
**Armonk, N.Y. 10504 (US)**

(72) Erfinder: **Simi, Victor M.**
**Clays Mill Extension, Rt. Nr. 1**
**Lexington, Kentucky 40503 (US)**
**Soderman, Donald A.**
**2606 Lakevale Drive**
**Vienna, Virginia 22180 (US)**

(74) Vertreter: **Herzog, Joachim Dipl.-Ing**
**Schönaicher Strasse 220**
**D - 7030 Böblingen (DE)**

## Halbleiter-Zellenstruktur für eine Eimerkettenschaltung sowie Verfahren zur Herstellung derselben

Die Erfindung bezieht sich auf eine Halbleiter-Zellenstrucktur für eine Eimerkettenschaltung sowie ein Verfahren zur Herstellung derselben; die Eimerkettenschaltung besteht aus einer Reihe von solchen hintereinander geschalteten Zellen, die gesteuert Ladungen von Zelle zu Zelle übertragen.

Es ist eine Halbleiter-Zellenstruktur gemäß dem Oberbegriff des Patentanspruchs 1 bekannt (französische Patentanmeldung 2 161 003), bei der für die Verwendung in einem Kondensatorspeicher eine Reihe von Zellen hintereinander geschaltet sind. Bei dieser Zellenstruktur sind in einem Halbleitersubstrat eines ersten Leitfähigkeitstyps niedrigen Widerstands ein erster Diffusionsbereich einer ersten Zelle mit einem zweiten Leitfähigkeitstyp und davon beabstandet ein zweiter Diffusionsbereich einer zweiten Zelle mit dem zweiten Leitfähigkeitstyp angeordnet. Desweiteren ist das Halbleitersubstrat an seiner Oberfläche mit einer Isolationsschicht bedeckt, auf der oberhalb des Zwischenraumes zwischen den Diffusionsbereichen eine Gateelektrode angebracht ist. — Die der Erfindung zugrundeliegenden Probleme und Schwierigkeiten, welche nachfolgend anhand von weiteren aus dem Stand der Technik bekannten Strukturen erläutert werden, sind dieser bekannten Anordnung zum einen fremd und zum anderen durch diese nicht gelöst.

Aus der Zeitschrift IEEE Transactions on Electron Devices Vol 23, Nr. 10, 1976, Seiten 1 187 bis 1 189 ist eine aus einem Transistor bestehend Speicherzelle bekannt, die aus einem Feldeffecttransistor besteht, dessen Drainzone einen außerhalb der Kanalzone liegenden implantierten Drainbereich aufweist, der das Inversionsgebiet der Speicherkapazität darstellt. Aus der US-A-3 959 025 sind Feldeffekttransistoren bekannt, an deren durch Diffusion hergestellte Source- und Drainzonen implantierte Source- und Drain-Gebiete anschließen, die mit Hilfe der Selbstausrichtung durch die Gateelektrode hergestellt worden sind.

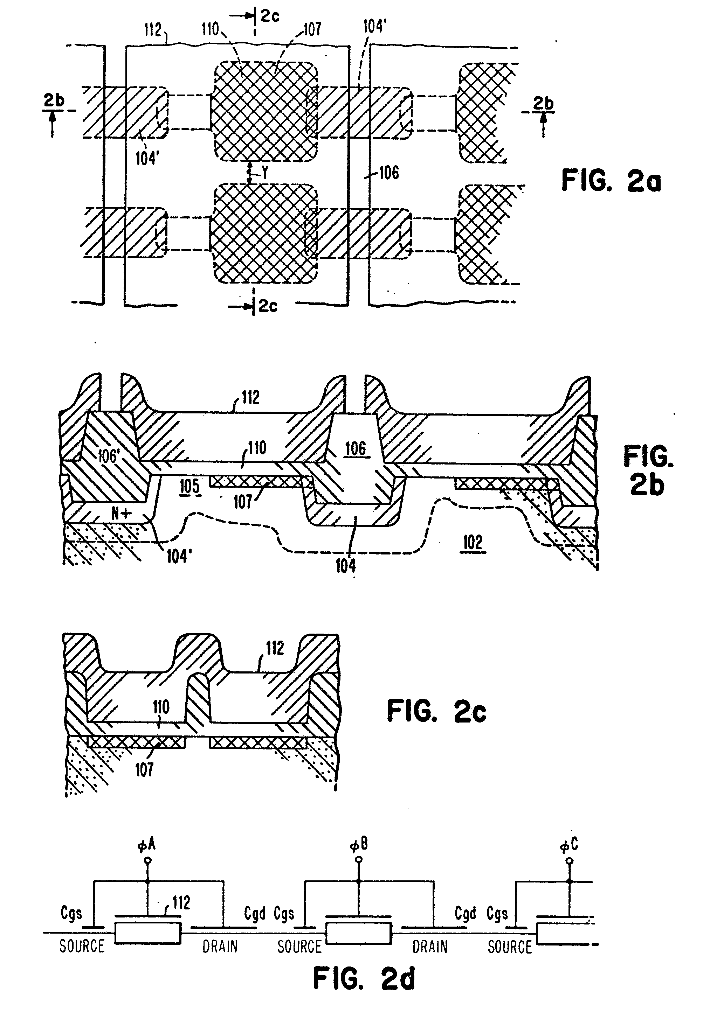

Eine Eimerkettenschaltung besteht aus einer Folge von hintereinander geschalteten Schalttransistoren, die Kapazitäten dadurch miteinander verbinden, daß die Gates alternierenden Transistoren in einer Folge durch nicht überlappende Zeitgabeimpulse beaufschlagt werden. Eimerkettenschaltungen werden vorteilhafterweise in der Technik der Feldeffekttransistoren ausgeführt, wodurch eine in der Struktur und in der Herstellung einfache Eimerkettenzelle erzielt wird. Ein Spanungs- bzw. Ladungssignal, das die Einheit einer binären Information repräsentiert, wird an der Source der ersten der Reihe von FET-Eimerkettenzellen eingespeist. Wenn der erste Taktimpuls am Gate der ersten Eimerkettenzelle auftritt, wird de vorher rückgestellte Drainknoten im Bootstrapverfahren durchlässig gemacht, so daß Strom durch den FET fließt und die Einheit der Binärinformation zu der Speicherkapazität zwischen der ersten und zweiten Zelle übertragen wird. Danach, wenn der Taktimpuls am Gate der zweiten Eimerkettenzelle auftritt, wird die Einheit der Binärinformation, die am Kapazitätsknoten zwischen der ersten und der zweiten Zelle gespeichert ist, durch die zweite Zelle zu dem vorher rückgestellten Kapazitätsknoten zwischen der zweiten und dritten Zelle übertragen. In diese Weise kann ein Spannungs- bzw. Ladungssignal durch einen Strang von Eimerkettenzellen tranferiert werden, bei Nutzung eines Zweiphasentaktes, um einen seriellen Speicher, eine Signalübertragung oder eine Signalbearbeitungs-Arbeitsweise durchzuführen. Diese Arbeitsweise ist schematisch in Fig. 1d dargestellt. Für jede Ladungsübertragung ist immer eine Zelle vorgesehen, die bei Beginn der Arbeitsweise ohne übertragene Ladung ist. Diese leere Zelle wird auf ein Referenzpotential, das der letzten Zelle in der Kette entspricht, aufgefrischt, wobei dieses in der zum Informationsfluß umgekehrten Richtung fortschreitend durchgeführt wird. Auf diese Weise werden bei einer zweiphasigen Taktgebung 2N Zellen benötigt, um N Bits an Informationen zu speichern. Die Anzahl der Zellen kann auf

$$\frac{(m)}{m-1} N$$

reduziert werden bei einer mehrphasigen Taktgebung mit m Takten, um N Informationsbits zu speichern.

Für den Aufbau einer guten Eimerkettenzelle müssen eine Anzahl von voraussetzungen erfüllt werden. Eimerkettenzellen werden nicht in Alleinstellung verwendet, sondern in kettenförmiger Anordnung einer größer Anzahl von ihnen, weswegen die Zelle in der Dimension klein sein muß und an die Erfordernisse der Herstellung in integrierter Schaltungstechnik hoher Dichte anpaßbar sein muß. Da lange Ketten dieser Zellen für viele Anwendungen notwendig sind, muß die Übertragungseffizienz jeder Zelle nahe bei 1 liegen und darf nicht unterschiedlich sein bei der Übertragung einer binären 0 oder bei der Übertragung eines binären 1-Signals.

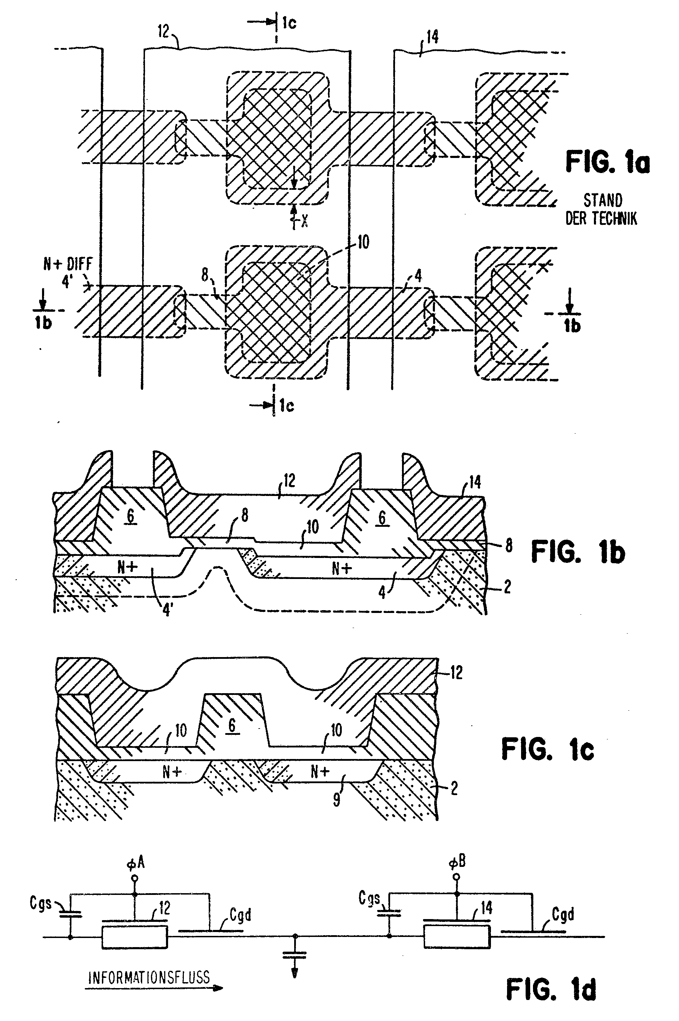

In Fig. 1a ist eine Implementierung einer aus dem Stand der Technik bekannten Eimerkettenzelle dargestellt, in Fig. 1b ein Querschnitt dieser Zelle entlang der Linie 1b—1b und in Fig. 1c ist ein Querschnitt entlang der Linie 1c—1c von Fig. 1a dargestellt. Die Eimerkettenzelle, die in den Figuren a1 bis 1c dargestellt ist, weist ein Metallgate auf, das, obwohl es kein Self-Aligned-Gate aufweist, einfacher in der Fabrikation ist als polykristalline Silicium-Self-Aligned-Gate-Anordnungen, wodurch eine ebenere Oberflächenkontur erzielbar ist, auf der Photolithographie mit größerer Auflösung vorgenommen werden kann. Die dargestellte, aus dem Stand der Technik bekannte Eimerkettenzelle ist als Teile einer integrierten Schaltung in einem P-leitenden Halbleitersubstrat 2 hergestellt und weist eine N+ leitende Diffusionszone 4 auf, die als ihr kapazitiver Speicherknoten dient. Unter der dicken Oxydschicht 6 in Fig. 1b befindet sich der Diffusionsbereich 4', dessen rechte Seite als Source in der Eimerkettenanordnung 12 dient und dessen linke Seite als Teil der Drain für die Eimerkettenanordnung auf der linken Seite der Anordnung 12 dient. Die in Fig. 1b dargestellte bekannte Zelle weist eine dicke Schicht 6 aus Siliciumdioxid auf, die zum Trennen der Gates 12 und 14 von benachbarten Eimerkettenzellen dient. Zwischen den dicken Schichten 6 aus Siliciumdioxid ist eine dünne Schicht aus Siliciumdioxid mit einem relativ dünnen Teil 8 angeordnet, deren typische Dicke in der Größenordnung von 50 bis 100 nm liegt und ein etwas dickerer Teil 10, der eine übliche Dicke in der Größenordnung von ca. 100 nm bis 150 nm aufweist. Die Gate-Metallelektrode 12 der Eimerkettenzelle ist zwischen den dicken Schichten 6 aus Siliciumdioxid angebracht und zwar über den Oxidschichten 8 und 10. Eine unterschiedliche Oxidschichtdicke unterhalb der Gate-Elektrode 12 einer Nicht-Self-Aligned-Gate-FET-Anordnung im Bereich zwischen den Bereichen 6 und 8 gemäß Fig. 1b ist gemäß der Lehre des Standes der Technik wünschenswert, um parasitäre kapaiztive Kopplung zwischen dem Gate 12 und der Source-Diffusion 4' zu reduzieren. In der Tat sind solche Anordnungen auf Chips mit großer Integrationsdichte vorhanden, die auch eine Eimerkettenschaltung enthalten, um andere logische und Eingangs-/Ausgangsoperationen vorzunehmen. Der Herstellprozeß dieser bekannten Art bei der Bildung des dickeren Bereichs beruht auf der verstärkten Oxidationsrate stark dotierten Siliciums, wie beispielsweise solches in den Diffusionsbereichen 4'. Jedoch ist mit diesem Vorteil der Nachteil verbunden, daß die entsprechende Oxidschicht 10 über dem Diffusionsbereich 4 wächst, was gleichzeitig die Kapazität zwischen dem Gate 12 und dem Diffusionsbereich 4 reduziert. Dieser nachteilige Effekt tritt dann besonders in Erscheinung, wenn diese FET-Vorrichtung als ein Element einer Eimerkettenschaltung verwendet wird, da der Ladungsspeicherknoten der Zelle der zwischen dem Gate und dem Diffusionsbereich gebildet ist, eine reduzierte Kapazität pro Flächeneinheit aufweist.

Der kapazitive Speicherbereich einer Eimerkettenzelle ist generell an dem Teil 10 der dünnen oxidschicht zu finden und der Feldeffektschaltteil der Eimerkettenzelle ist generell am Teil 8 der dünnen Oxidschicht angeordnet. Die dargestellte bekannte Eimerkettenzelle weist Nachteile auf, die typisch für den Stand der Technik sind. Im Stand der Technik ist das Problem noch nicht erkannt und auch nicht gelöst, welches darin besteht auf demselben integrierten Chip sowohl unterschiedliche logische Oxid-FET-Vorrichtungen als auch Eimerkettenschaltungen mit einer minimalen Dicke der Siliciumdioxidschicht 10 im kapazitiven Speicherbereich zu vereinen, um somit die Kapazität pro Flächeneinheit zu maximieren und gleichzeitig die Dicke der Oxidschicht zwischen den Bereichen 6 und 8 in Fig. 1b zu vergrößern, um die kapazitive Kopplung zur Source zu minimieren. Die Ladungswanderung entlang einer Eimerkette, wie sie in Fig. 1b als Schaltbild dargestellt ist, ist das Ergebnis eines kapazitiven Bootstraping-Verfahrens, bei dem die Größe der Ladungsverschiebung von Knoten zu Knoten eine Funktion der Differenz der Größe zwischen der Gate-Source-Kapazität $C_{gs}$ und der Gate-Drain-Kapazität $C_{gd}$ ist. Umso größer $C_{gd}$ gegenüber $C_{gs}$ ist, umso größer ist die Größe der verschobenen Ladung. Da die minimale Kapazität pro Eimerkettenzelle zum Erzielen eines detektierbaren Ausgangssignals für eine besondere Anwendung notwendig ist, muß die Zelle bereichsmäßig größer gemacht werden, um die Kapazitätserfordernisse zu erfüllen.

Ein anderes mit der aus dem Stand der Technik bekannten Eimerkettenzelle, wie sie typisiert durch Fig. 1a bis 1c dargestellt ist, verbundenes Problem liegt in der Unmöglichkeit, eine Selbstausrichtung der Strukturelemente der Eimerkettenzelle vorzunehmen, so daß der Abstand X, der für die Ausrichttoleranzen notwendig ist, die zwischen dem Diffusionsbereich 4 und den Gateoxid-Ätzstufen notwendig sind, zu klein ist. Dieses führt notwendigerweise dann dazu, den Trennungsabstand zwischen benachbarten Ketten der Eimerkettenzellen größer zu machen. Andere schwierige Probleme liegen darin, daß ein Kanalkurzschluß auftreten kann, wenn benachbarte Zellen innerhalb derselben Eimerkettenschaltung zu nahe aneinander gebracht werden. Aufgrund der wesentlichen vertikalen Tiefe des Diffusionsbereichs 4 gemäß Fig. 1b, gegenüber dem Kanalbereich zwischen den Diffusionsbereichen 4 und 4', wird die Trennungsdistanz zwischen diesen Diffusionsbereichen 4 und 4' reduziert, so daß die Schwellwertspannung für den Feldeffekttransistorteil der Eimerkettenvorrichtung unterhalb der dünnen Oxidschicht 8 gegenüber der Größe der Spannungsdifferenz zwischen den Diffusionsbereichen 4 und 4' empfindlich wird. Dies verursacht, daß die Schwellwertspannung und damit die Ladungsübertragungseffizienz der Vorrichtung, unterschiedlich für binäre Eins-Signale und für binäre Null-Signale sind. Da die Schwellwertspannung und die Effizienz der Ladungsübertragung von dem logischen Wert des zu übertragenden Signals abhängig wird, können lange Ketten solcher Eimerkettenzellen eine Verminderung der übertragenen Signals beinhalten, die besonders offenkundig bei dem ersten untershiedlichem Bit einer Sequenz auftreten.

Hier will die Erfindung Abhilfe schaffen. Die Erfindung, wie sie in den Ansprüchen gekennzeichnet ist, löst die Aufgabe, die Packungsdichte für Eimerkettenschaltungen durch die Zellgestaltung zu erhöhen, die Empfindlichkeit der Schwellwertspannung einer Eimerkettenschaltung in Abhängigkeit von der Spannungsgröße zwischen Source und Drain zu reduzieren, die überlappende Kapazität zwischen Gate und Source zu minimieren und die überlappende Kapazität zwischen Gate und Drain in der Eimerkettenanordnung zu maximieren, weiterhin die Aufgabe, die Probleme mit dem kurzen Kanaleffekt in einer Eimerkettenschaltung zu reduzieren und darüber hinaus auf demselben integrierten Chip sowohl FET logische Schaltungen mit reduzierten parasitären Kapazitäten als auch Eimerkettenschaltungen mit maximierter Gate-Drain-Kapazität pro Flächeneinheit vereinen zu können.

Die durch die Erfindung erreichten Vorteile liegen im wesentlichen darin, daß eine Zellenstruktur für eine Eimerkettenschaltung geschaffen ist, die eine MOS-Kapazität mit einem MOS-FET vereint, mit einer Schwellwertspannung, deren Empfindlichkeit gegebüber dem Source-Drainpotential reduziert ist, damit eine höhere Ladungsübertragungseffizienz erreicht ist, die Zelle in ihren Abmessungen kleiner gestaltet werden kann, eine reduzierte parasitäre Kapazität zum Substrat erzielt ist, aufgrund der reduzierten Seitenwandbereiche der ionenimplantierten Drain und somit insgesamt die Packungsdichte erhöht ist.

Im folgenden wird die Erfindung anhand des in den Figuren erläuterten Ausführungsbeispieles das Lediglich einen Ausführungsweg darstellt, in Aufbau und Wirkungsweise näher erläutert.

Die Figuren zeigen im einzelnen:

Fig. 1a eine Draufsicht auf eine Eimerkettenanordnung, die aus dem Stand der Technik bekannt ist;

Fig. 1b eine Seitenansicht des Schnitts entlang der Linie 1b—1b aus Fig. 1a;

Fig. 1c eine Seitenansicht des Schnitts entlang der Linie 1c—1c aus Fig. 1a;

Fig. 1d ein schematisches elektrisches Schaltbild der in Fig. 1a dargestellten Eimerkettenanordnung;

Fig. 2a eine Drausicht auf ein Ausführungsbeispiel gemäß der Erfindung, die die verbesserte Eimerkettenschaltung mit der implantierten Drainvergrößerung zeigt;

Fig. 2b eine Seitenansicht des Schnitts entlang der Linie 2b—2b aus Fig. 2a;

Fig. 2c eine Seitenansicht des Schnittbildes entlang der Linie 2c—2c aus Fig. 2a;

Fig. 2d schematisch ein elektrisches Schaltbild der erfindungsgemäß gestalteten Eimerkettenanordnung aus Fig. 2a;

Fign. 3a bis 3e zeigen die Folge von Prozeßschritten, die zur Herstellung der in Fig. 2 dargestellten Eimerkettenanordnung vorteilhaft angewendet werden;

Fig. 4 eine graphische Darstellung der Beziehung zwischen der Empfindlichkeit der Eimerkettenanordnung bzw. das Verhältnis, der Schwellwertspannung zu der Source-Drainspannung in Abhängigkeit von der effektiven Kanallänge der Anordnung; und

Fig. 5 eine graphische Darstellung der Abhängigkeit des Übertragungsverlustes pro Stufe von der effektiven Kanallänge bei einer Eimerkettenanordnung der in Fig. 2 gezeigten Ausführung.

Die in der Fig. 1 dargestellte, aus dem Stand der Technik bekannte Anordnung ist in der Einleitung vorliegender Beschreibung bereits abgehandelt worden, weswegen jetzt hier nicht näher auf diese mehr eingegangen werden muß.

Um für eine Eimerkettananordnung optimale Verhältnisse zu schaffen, muß die dünne überlappende Kapazität zwischen Gate und Drain maximiert werden, während gleichzeitig die parasitären Kapazitäten zwischen Gate und Source sowie zwischen dem Diffusionsbereich und dem Substrat minimal gehalten werden müssen. Zusätzlich sollte die Strom-Spannungscharakteristik, die in Beziehung zur Schwellwertspannung des Feldeffekttransistorens steht, unabhängig von der Drain-Source-Spannung sein und die Leitfähigkeit im durchgeschalteten Zustand sollte sehr hoch sein, um eine maximale Übertragungseffizienz sowohl bei niedrigen als auch bei hohen Arbeitsfrequenzen zu erzielen. Zusätzlich soll die Anordnung möglichst eng gepackt werden können, um für optimale Bitdichte minimalen Platz zu erreichen und dabei eine hohe Ausbeute des Halbleiterchips zu erzielen. Alle diesen Kriterien werden von der in den Fign. 2a—2c dargestellten Halbleiterzelle für eine Eimerkettenschaltung erfüllt. Bei dieser Anordnung ist ein kapazitiver Speicherbereich mit dem Schaltbereich des Feldeffekttransistors vereint durch Anwendung einer gleichförmigen Dicke der dünnen Isolationsschicht 110, die sich über eine Drain-Vergrößerung 107 erstreckt, die ionenimplantiert ist, um einen kapazitiven Speicherknoten für die Eimerkettenzelle zu bilden.

In den Fign. 2a und 2b ist eine Folge von miteinander seriell verbundenen Eimerkettenzellen dargestellt, während in der Fig. 2c eine Zelle von einem Paar benachbarter Eimerketten dargestellt ist. Die Zellen sind aus Elementen eines integrierten Schaltkreises gebildet und zwar in einem p-leitenden Halbleitersubstrat 102, das einen Widerstand zwischen etwa 1,3 und 1,7 Ohm cm aufweist. Dieses Substrat mit niedrigem Widerstand hilft bei der reduzierung der Kanalkurzschlüsse und der elektrostatischen Rückkopplungseffekte, wodurch die Empfindlichkeit der Schwellwertspannung gegenüber der Source-Drainspannung reduziert wird.

Ein zweiter Diffusionsbereich 104 als Sourcebereich einer zweiten Zelle, die durch ein Gate 112 angedeutet ist, wird in der Fläche des Halbleitersubstrats gebildet und hat eine n-Leitung durch Dotierung des Substrates mit Phosphor oder Arsen.

Ein erster Diffusionsbereich 104' als Sourcebereich für eine erste Zelle, auf der linken Seiten der zweiten Zelle in Fig. 2b, wird durch eindiffundierung von n-Leitungstypen in das p-leitende Substrat gebildet und ist von dem zweiten Diffusionsbereich 104 beabstandet, so daß der Substratbereich zwischen beiden den kapazitiven Speicherknoten und auch den Feldeffekttransistor-Schaltbereich für die erste Zelle bildet. Eine dicke Isolationsschicht 106 aus Siliziumdioxid ist über den Diffusionsbereichen 104 und 104' gebildet. Eine dünne Isolationsschicht 110 mit aus Oxid mit einer gleichförmigen Dicke ist über dem Halbleitersubstrat 102 in dem Bereich zwischen den dicken Isolationsschichten 106 gebildet. Ein Übergansoxidbereich zwischen der dünnen Isolationsschicht 110 und der dicken Isolationsschicht unterhalb der Gateelektrode 112 hat eine größere Dicke als es der Dicke der dünnen Isolationsschicht 110 entspricht, um die parasitäre Kapazität zwischen der Gateelektrode 112 und dem ersten Diffusionsbereich 104' zu reduzieren. Ein Drainvergrößerungsbereich 107 ist durch Ionenimplantierung eines n-leitenden Doterriungsstoffes, wie Phosphor oder Arsen, durch die dünne Isolationsschicht 110 hindurch gebildet, um einen Teil des gesamten Bereiches zwischen den Diffusionsbereichen 104 und 104' einzunehmen, wobei ein Kanalbereich 105, der die anfängliche Substratleitfähigkeit aufweist, freigelassen ist, der Kanalbereich liegt somit zwischen dem implantierten Drainvergrößerungsbereich 107 und dem ersten Diffusionsbereich 104'. Die Dicke des ionenimplantierten Drainvergrößerungsbereichs 107 ist wesentlich dünner als es der Tiefe der Diffusionsbereiche 104 oder 104' unterhalb der Fläche des Halbleitersubstrats 102 entspricht und liegt in der Größenordnung von ca. 50 nm bis 200 nm.

Die Gateelektrode 112 aus Fig. 2b weist einen Abstand von Mitte zu Mitte, d.h. zwischen den dicken Isolationsschichten 106 und 106', der Zellenperiodizität, von 20 $\mu$m auf, die Tiefe des zweiten Diffusionsbereichs 104 unterhalb der Oberfläche des Substrats beträgt ca. 1,9 $\mu$m, die Tiefe des ionenimplantierten Drainvergrößerungsbereichs 107 beträgt ca. 100 nm, die Länge des Drainvergrößerungsbereichs 107 beträgt etwa 8 $\mu$m, die Länge des Kanalbereichs 105 beträgt etwa 5 $\mu$m, die Tiefe der dicken Isolationsschicht 106 beträgt ca. 300 nm unterhalb der Substratoberfläche und die Dicke der dünnen Isolationsschicht 110 beträgt ca. 50 nm. Eine metallische Gateelektrode 112 ist über der dünnen Isolationsschicht 110 angeordnet, wobei dadurch die in den Fign. 2a—2c dargestellten Struktur komplettiert ist.

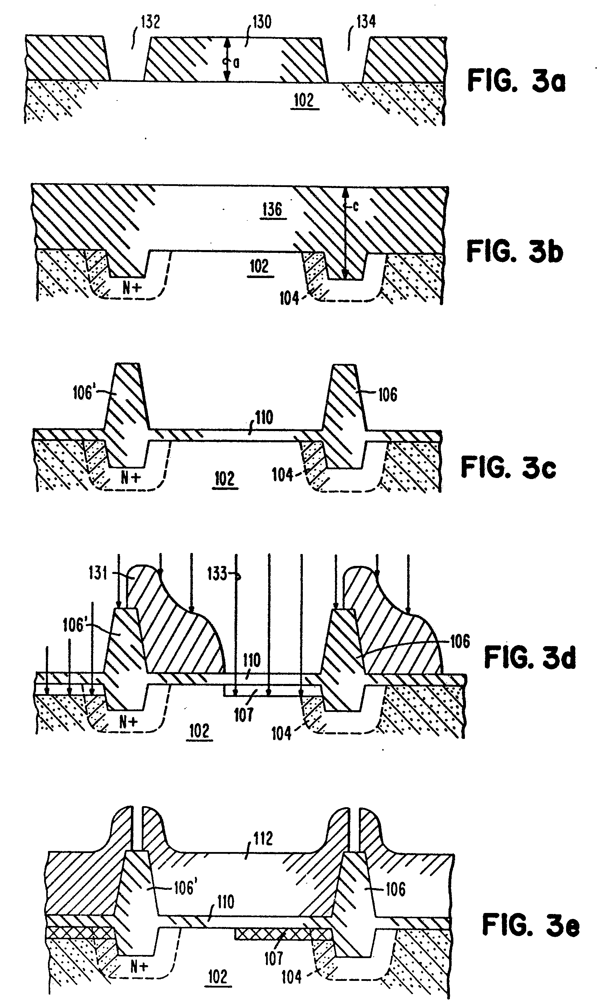

Das Verfahren zur Herstellung der erfindungsgemäßen und in den Fign. 2a—2c gezeigten Struktur wird nachfolgend anhand der Fign. 3a—3e erläutert. Das Verfahren beginnt bei Fig. 3a unter Zuhilfenahme eines p-leitfähigen Siliciumsubstrats 102 mit einer Leitfähigkeit von 1,5 Ohm cm durch Aufwachsen einer Anfangsoxidschicht 130 mit einer Dicke a von 300 nm durch einen konventionellen thermischen Oxidationsprozeß. Fenster bzw. Öffnungen 132 und 134 werden dann in die Oxidschicht 130 geätzt. Die Diffusionsbereiche 104 und 104' werden dann durch Ablagerung/Aufwachsen eines 5 Mol prozentigen Phosphorsilicatglases über der thermischen Oxidschicht 130 unter Freilassung der Fenster 132 und 134 bei einer Temperatur von 870°C für ca. 25 Minuten gebildet. Danach folgt der Source-Drain-Eintreibzyklus bei 900°C in einer Dampfatmosphäre für etwa 250 Minuten. Die resultierende Dicke des Phosphorsilicatglases und der thermisch gewachsenen Oxidschicht über den Diffusionsbereichen 104 und 104' ist mit c angegeben und beträgt dann ca. 950 nm. Das Ergebnis dieses Herstellungsschrittes ist in Fig. 3b dargestellt und zeigt, daß eine sehr ebene Oberfläche der Schicht 136 erreicht ist, die eine gute photolithographische Auflösung bietet.

Danach wird ein photolithographischer Ätzprozeß angewandt, um die dicken Isolationschichten 106 und 106', wie sie in Fig. 3c dargestellt sind, zu bilden. Diesem Schritt folgt ein Gateoxid-Aufwachsschritt, um die dünne Isolationsschicht 110, die in Fig. 3c dargestellt ist, durch einen trockenen thermischen Oxidationsprozeß bei 900°C für ca. 250 Minuten zu bilden.

Eine dünne Phosphorsilicatglasschicht wird bis zu einer Dicke von 110 nm abgelagert bzw. aufgewachsen auf der Oberfläche der Isolationsschicht 110 und bei 1000°C für 20 Minuten aufgeheizt, um durch einen Getterungsprozeß ionenverschmutzungen zu entfernen, um eine bessere Schwellwertspannung-Stabilität zu erhalten. Das Ergebnis dieses Schrittes ist in Fig. 3c dargestellt.

Der nächste Schritt beinhaltet in konventioneller Weise die Ablagerung einer Photoresistschicht 131 von etwa 1 um Dicke über einem Teil der dünnen Isolationsschicht 110 und dem direkt benachbarten Teil der dicken Isolationsschicht 106', wie dies in Fig. 3d dargestellt ist, um somit eine Ionenimplantationsmaske zu erreichen, durch die hindurch eine Ionenimplantierung 133 von Phosphorionen bei ca. 65 KeV erfolgt. Für eine dünne Isolationsschicht 110 mit einer Dicke von ca. 50 nm ergibt sich bei einer 65 KeV Phosphorionenstrahldosis von $10^{13}$ Atome/cm², der n-leitende Drainvergrößerungsbereich 107, der in Fig. 3d dargestellt ist letzlich nach einem Heizprozeß bei 450°C für 10 Minuten. Diese Konzentration des Drainvergrößerungsbereichs 107 stellt sicher, daß sie n-leitend bleibt bei allen gewünschten Gate- und Drain-Potentialen.

Die letzten Schritte in Fig. 3e sind photolithographische Ätzverfahrensschritte für die Kontaktierung und das Aufwachsen der metallisierten Gateanschlüsse aus Aluminiumkupfer und das Ausätzen der Metallstrukturen, die den Herstellprozeß vervollständigen.

Wahrend der Folge von Prozeßschritten, die in den Fig. 3a—3e dargestellt sind, um die erfindungsgemäße Eimerkettenzellenstruktur herzustellen, sind auf demselben integrierten Chip logische Schaltungen in FET-Technik gebildet worden, die eine reduzierte Gate-Diffusion-Kapazität aufweisen aufgrund des Unterschiedes der Oxiddicken zwischen ihren Kanalbereichen und ihren Diffusionsbereichen.

Bei der erfindungsgemäßen Eimerketten-Zellenstruktur, wie sie in Fig. 2b dargestellt ist, ist bei niedrigen Frequenzen die Übertragungseffizienz dadurch verbessert, daß die Veränderungen in der Schwellwertspannung im Hinblick auf die Änderungen des Source-Drainpotentiales minimiert sind. Dies wird auf zwei Wegen erreicht, zum ersten durch Reduzierung des Widerstandes des Substrats und zum zweiten durch Reduzierung der effektiven Übergangstiefe der ionenimplantierten Drainvergrößerungsbereiche hohen Widerstandes und des dem Kanal am nächsten liegenden Drainteils. Wenn die Drain-Substrat- oder Drain-Source-Spannung ansteigt, dann wächst die Verarmungsschicht an dem pn-Übergang an der breite n und an der vertikalen Seite der Drain, die am nächsten dem Kanal ist, und reduziert effektiv die Kanallänge durch ein progressives Übergreifen in den Kanalbereich. Da der Trennungsabstand zwischen dem Sourcebereich, der die Drain umgibt, mit einem entsprechenden Verarmungsbereich, der die Source umgibt, zusammenfällt und dadurch eine kontinuierliche Verarmungszone unterhalb des Gates gebildet wird, ist die Ladungsträgerkonzentration an der Oberfläche weniger durch die Spannung am Gate veränderbar. Dies bedeutet, daß die Schwellwertspannung gegenüber der Source-Drain-Spannung sensitiv geworden ist, was dem bekannten kurzen Kanaleffekt entspricht.

Durch Erhöhung der Substratdotierungskonzentration wird die Änderungsrate an der Drainverarmungsschichtdicke mit einer Änderung in der Drain-Substratspannung reduziert, wodurch wiederum die Änderungsrate der effektiven Kanallänge im Hinblick auf die Drain-Substratspannung reduziert wird, was letzlich die Empfindlichkeit der Schwellwertspannung gegenüber der Drain-Substratspannung vermindert.

Durch die erfindungsgemäße Einführung des flachen, ionenimplantierten Drainvergrößerungsbereichs 107, ist die Drainverarmmungsschicht auf einen Bereich begrenzt, der den flachen Drainvergrößerungsbereich 107 umgibt und nahe an der Oberfläche des Substrats liegt, an der eine viel größere Steuermöglichkeit der Ladungsträger durch das Gate aufrechterhalten werden kann. Da die Vereinigung der Verarmungsschichten zwischen der Source und der Drain im Kanalbereich wesentlich näher an der Oberfläche erfolgt als in idealeren langkanaligen FETs, ist die Schwellwertspannung viel weniger sensitiv gegenüber Veränderungen der Drain-Substrat- oder der Drain-Source-Spannung.

In einer Eimerkettenzelle ist die Unempfindlichkeit der Schwellwertspannung gegenüber der Source-Drain- oder der Drain-Substrat-Spannung wesentlich für eine beständige Übertragung derselben Ladungsquantität für einen gegebenen Binärwert, unabhängig von dem Binärwert der vorhergehenden oder nachfolgenden Ladungssignale. Eine solche Abhängigkeit resultiert in einer Restladung am Speicherknoten für einen ersten binären Wert, der dann mit dem Ladungssignal für den entgegengesetzten Binärwert mitübertragen wird, wodurch fehlerhaft akumulierte Ladungsamplituden weiter übertragen und vorgeschoßen werden. Durch Erhöhung der Substratleitfähigkeit und Einführung des ionenimplantierten Drainverlängerungsbereichs 107 gemäß der Erfindung, ist die Ladungsübertragungseffizienz der Eimerkettenzelle bei niedrigen Frequenzen verbessert.

Bei hohen Frequenzen, bei denen die Kanallänge die Übergangszeit für ein Ladungssignal bestimmt, verbessert sich die vorhandene Übertragungseffizienz mit dem reduzierten Kanalwiderstand, der sich aus der Koexistenz der reduzierten effektiven Kanallänge und der gesteigerten Leitfähigkeit der Eimerkettenzelle gemäß der Erfindung ergibt.

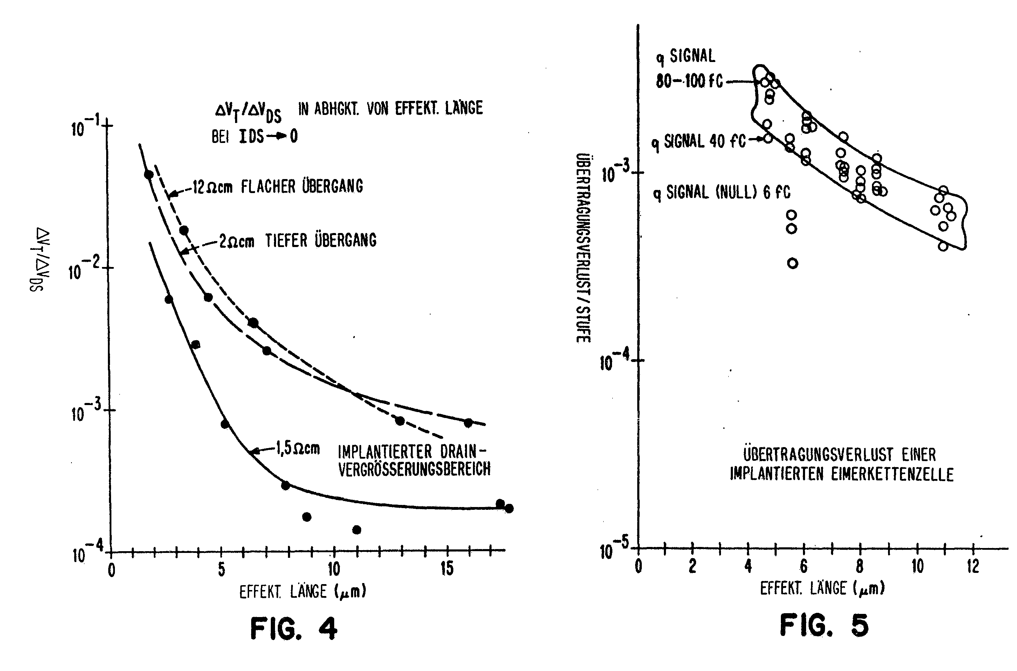

Fig. 4 zeigt den graphischen Zusammenhang zwischen der Empfindlichkeit der Schwellwertspannung gegenüber der Drain-Sourcespannung $\Delta V_T / \Delta V_{DS}$ bei gesättigter Eimerkettenbetriebsweise, wenn der Drain-Sourcestrom IDS gegen Null geht in Abhängigkeit von der effektiven Kanallänge; dies einmal für zwei herkömmliche Eimerkettenanordnungen und zum anderen einmal für die erfindungsgemäß gestaltete Eimerkettenzelle. Die Figur zeigt, daß bei einer Eimerkettenzelle mit einem 1,5 Ohm cm Substrat und einem ionenimplantierten Drainvergrößerungsbereich gemäß der Erfindung eine wesentlich reduzierte Schwellwert-Sensitivität erzielt wird, und daß deswegen niedrigere Übertragungsverluste auftreten als dies bei einer Eimerkettenzelle der Fall ist, die ein 12 Ohm cm Substrat und einen flachen (0,8 $\mu$m) Übergang aufweist, oder bei einer solchen mit einem 2 Ohm cm Substrat und einer Übergangstiefe von 2,7 $\mu$m.

In Fig. 5 ist graphisch wiedergegeben die Beziehung zwischen dem gemessenen Übertragungsverlust pro einzelner Stufe in Abhängigkeit von der effektiven Kanallänge bei der erfindungsgemäßen Anordnung für unter-Signalladungspegel bei einer Arbeitsfrequenz von 200 kHz. Der gemessene Übertragungsverlust pro Stufe schließt sowohl den Verlust aufgrund der Schwellwertsensitivität als auch Verluste ein, die aus anderen Quellen resultieren. Anordnungen gemäß der Erfindung, die sieben verschiedene Kanallängen aufweisen, sind dazu untersucht worden bei verschiedenen Ladungssignalamplituden, die von 40 bis 100 Femto-Coulomb reichen, und ihre dabei entstehenden Übertragungsverluste pro Stufe sind gemessen und eingetragen worden. Das Schaubild zeigt, daß die Abhängigkeit des Ladungsübertragungsverlustes pro Stufe von der Ladungssignalamplitude relativ gering ist und daß der gesamte Übertragungsverlust pro Zelle genügend klein ist, so daß eine Verkettung von einer großen Anzahl solcher Zellen ohne den Einschluß einer wesentlichen Signalstörung vorgenommen werden kann.

Die Effizienz der Ladungsübertragung in einer Eimerkettenanordnung ist eine Funktion der folgenden Faktoren:

1. Statische Oberflächenverluste aufgrund des Wiedereinfangens von Elektronen und des Ladungsverlustes,

2. Modulation der Schwellwertspannung durch die Drain-Sourcespannung,

3. Parasitäre Kapazitäten zwischen Drain und Substrat, die
a) ein kapazitives Aufladen der nachfolgenden Eimerkettenzelle in einer Kettenanordnung bewirken und
b) eine kapazitive Aufladung der Gate-Taktleitungen ØA, ØB und ØC verursachen.

Die erfindungsgemäß gestaltete Eimerketten-Zellenstruktur weist eine verbesserte Ladungsübertragungseffizienz durch Verbesserung der Faktoren 2, 3a und 3b auf, wie sie vorstehend genannt wurden. Der reduzierte Seitenwandbereich des Drainverlängerungsbereichs 107, der dem Kanalbereich 105 gegenübersteht, wie dies in Fig. 2b gezeigt ist, reduziert den Einfluß der Veränderungen in der Dicke der Verarmungsschicht, die den Drainvergrößerungsbereich 107 umgibt, auf die effektive Kanallänge. Die reduzierten Seitenwandbereiche des Drainvergrößerungsbereichs 107, reduzieren für die seitlichen, lateralen Flächen, die parallel zur Ebene der Fig. 2b sind, die kapazitive Kopplung zwischen den ionenimplantierten Drainvergrößerungsbereich 107 und dem Substrat 102. Diese strukturellen Verbesserungen heben die obere Abschnittfrequenz der Eimerkettenanordnung an und verbessern gleichzeitig deren Ladungsübertragungseffizienz.

**Patentansprüche**

1. Halbleiter-Zellenstruktur für eine Eimerkettenschaltung mit einer Reihe von solchen hintereinander geschalteten Zellen, die gesteuert Ladungen von Zelle zu Zelle übertragen, bei der in einem Halbleitersubstrat (102) eines ersten Leitfähigkeitstyps (P) mit niedrigem Widerstand ein erster Diffusionsbereich (104') einer ersten Zelle mit einem zweiten Leitfähigkeitstyp (N⁺), und davon beabstandet ein zweiter Diffusionsbereich (104) einer zweiten Zelle mit dem zweiten Leitfähigkeitstyp (N⁺) angeordnet sind und das Halbleitersubstrat (102) an seiner Oberfläche mit einer Isolationsschicht (110, 106) bedeckt ist, auf der oberhalb des Zwischenraums zwischen den Diffusionsbereichen (104', 104) eine Gateelektrode (112) angebracht ist, gekennzeichnet durch
a) einen ionenimplantierten Drainvergrößerungsbereich (107) des zweiten Leitfähigkeitstyps (N⁺) für die erste Zelle, der zwischen dem ersten (104') und dem zweiten (104) Diffusionsbereich angeordnet, seriell mit dem zweiten Diffusionsbereich (104) verbunden und vom ersten Diffusionsbereich (104') durch einen Kanalbereich (105) getrennt ist, wobei der Drainvergrößerungsbereich (107) eine gegenüber den Diffusionsbereichen (104, 104') geringere Dicke aufweist,
b) eine dünn ausgebildete Isolationsschicht (110) über dem Kanal- (105) und ionenimplantierten Drainvergrößerungsbereich (107),
c) eine dick ausgebildete Isolationsschicht (106, 106') über den Diffusionsbereichen (104, 104').

2. Halbleiter-Zellenstruktur nach Anspruch 1, dadurch gekennzeichnet, daß die Dicke des ionenimplantierten Drainvergrößerungsbereiches (107) zwischen 50 und 200 nm beträgt.

3. Halbleiter-Zellenstruktur nach einem der vorigen Ansprüche, dadurch gekennzeichnet, daß die dünne Isolationsschicht (110) über dem Kanal- (105) und ionenimplantierten Drainvergrößerungsbereich (107) gleichmäßig dick ist.

4. Halbleiter-Zellenstruktur nach einem der vorigen Ansprüche, dadurch gekennzeichnet, daß die Dotierungskonzentration für das Substrat (102) so gewählt ist, daß dessen Flächenwiderstand zwischen 1,3 Ohm cm und 1,7 Ohm cm liegt.

5. Halbleiter-Zellenstruktur nach Anspruch 4, dadurch gekennzeichnet, daß die Tiefe des p-n-Übergangs der Diffusionsbereiche (104, 104') in bezug auf die Oberfläche des Substrats (102) größer als 1,5 $\mu$m ist.

6. Halbleiter-Zellenstruktur nach Anspruch 5, dadurch gekennzeichnet, daß die Dosis der Dotierung des zweiten Leitfähigkeitstyps in dem ionenimplantierten Drainvergrößerungsbereich (107) ca. $10^{13}$ Atome/cm² beträgt.

7. Halbleiter-Zellenstruktur nach einem der vorigen Ansprüche, dadurch gekennzeichnet, daß der Abstand zwischen den einander zugekehrten Seitenwänden der Diffusionsbereiche (104, 104') etwa 13 $\mu$m und die Länge des Kanalbereichs (105) etwa 5 $\mu$m beträgt.

8. Verfahren zur Herstellung der Halbleiter-Zellenstruktur nach einem der Ansprüche 1 bis 7, gekennzeichnet durch die Anwendung folgender Schritte:
a) Aufwachsen einer ersten SiO₂-Schicht

(130) auf ein Siliciumsubstrat eines ersten Leitfähigkeitstyps mit relativ niedriger Dotierungskonzentration,

b) Anbringen einer Mehrzahl von voneinander beabstandeten Zellenfenstern (132, 134) in der ersten SiO₂-Schicht (130),

c) Eindiffundieren einer Mehrzahl von Bereichen eines zweiten Leitfähigkeitstyps mit relativ hoher Dotierungskonzentration durch die Zellenfenster (132, 134) hindurch, wobei sich die Zellenfenster wieder schließen,

d) Bildung je eines Gate-Fensters in der ersten SiO₂-Schicht, zwischen benachbarten Paaren von Diffusionsbereichen (104, 104'), wobei die Gatefenster im wesentlichen mit den sich gegenüberstehenden Seiten der Diffusionsbereiche ausgerichtet sind,

e) Aufwachsen einer zweiten SiO₂-Schicht in den Gatefenstern und über der ersten SiO₂-Schicht, zur Bildung der dünnen Isolationsschicht (110),

f) Bildung einer Ionenimplantationsmaske (131) zur Abdeckung der dem zweiten Diffusionsbereich (104) zugewandten Seite des ersten Diffusionsbereiches (104') und eines Teils des benachbarten Gatebereiches unter Freilassung eines Oberflächengebietes für den Drainvergrößerungsbereich (107) in jedem Gatefenster auf der dem ersten Diffusionsbereich (104') zugewandten Seite des zweiten Diffusionsbereichs (104),

g) Ionenimplantierung zur Bildung eines flachen Drainvergrößerungsbereiches (107) des zweiten Leitfähigkeitstyps derart, daß er (107) kontinuierlich mit der dem ersten Diffusionsbereich (104') zugewandten Seite des zweiten Diffusionsbereiches (104) verbunden ist,

h) Entfernung der Ionenimplantationsmaske (131) und Bildung der Gateelektroden (112) in den entsprechenden Gatefenstern.

## Claims

1. Semiconductor cell structure for a bucket brigade device having several such cells serially connected and which are controlled to transfer charges from cell to cell, said structure having arranged in a low resistance semiconductor substrate (102) of a first conductivity type (P), a first diffusion region (104') of a first cell of a second conductivity type (N⁺) and spaced therefrom a second diffusion region (104) of a second cell of the second conductivity type (N⁺), the surface of the semiconductor substrate (102) being covered with an insulation layer (110, 106) on which a gate electrode (112) is provided over the space between the diffusion regions (104', 104) characterised by

a) an ion-implanted drain extension (107) of the second conductivity type (N⁺) for the first cell, said extension being arranged between the first (104') and the second (104) diffusion region, being serially connected to the second diffusion region (104) and being separated from the first diffusion region (104') by a channel region (105), the drain extension (107) having a thickness less than that of the diffusion regions (104, 104'),

b) a thin insulation layer (110) over the channel (105) and the ion-implanted drain extension (107), and

c) a thicker insulation layer (106, 106') over the diffusion regions (104, 104').

2. Semiconductor cell structure as claimed in claim 1, characterised in that the thickness of the ion-implanted drain extension (107) is between 50 and 200 nm.

3. Semiconductor cell structure as claimed in any one of the preceding claims, characterised in that the thin insulation layer (110) is of uniform thickness over the channel region (105) and the ion-implanted drain extension region (107).

4. Semiconductor cell structure as claimed in any one of the preceding claims, characterised in that the dopant concentration for the substrate (102) is such that its surface resistance is between 1.3 ohm cm and 1.7 ohm cm.

5. Semiconductor cell structure as claimed in claim 4, characterised in that the p-n junction depth of the diffusion regions (104, 104') with respect to the surface of the substrate (102) is greater than 1.5 $\mu$m.

6. Semiconductor cell structure as claimed in claim 5, characterised in that the concentration of the second conductivity type dopant in the ion-implanted drain extension region (107) is approximately $10^{13}$ atoms/cm².

7. Semiconductor cell structure as claimed in any one of the preceding claims, characterised in that the distance between the side walls facing each other of the diffusion regions (104, 104') is approximately 13 $\mu$m, and the length of the channel region (105) is approximately 5 $\mu$m.

8. Method of making a semiconductor cell structure as claimed in any one of claims 1 to 7, characterised by the following steps:

a) growing a first SiO₂ layer (130) on a silicon substrate of a first conductivity type having a relatively low dopant concentration,

b) providing a plurality of spaced cell windows (132, 134) if the first SiO₂ layer (130),

c) diffusing a plurality of regions of a second conductivity type of a relatively high dopant concentration through the cell windows (132, 134) while closing the cell windows again,

d) forming one respective gate window in the first SiO₂ layer between each adjacent pair of diffusion regions (104, 104'), the gate windows being substantially aligned between the adjacent edges of the pair of diffusion regions,

e) growing a second SiO₂ layer in the gate windows and over the first SiO₂ layer to form the thin insulation layer (110),

f) forming an ion-implantation mask (131) to cover that edge of the first diffusion region (104') adjacent the second diffusion rfegion (104) and part of the gate region, leaving uncovered a surface region over the drain extension region (107) in each gate window and that edge of the second diffusion region (104) adjacent the first diffusion region (104'),

g) ion-implanting to form a shallow drain extension region (107) of the second conductivity type in such a manner that it (107) is continuously connected to the edge of the second diffusion region (104) adjacent the first diffusion region (104'),

h) removing the ion-implantation mask (131) and forming the gate electrodes (112) in the respective gate windows.

## Revendications

1. Structure de cellules semi-conductrices pour un circuit "chaîne de seaux" comportant plusieurs cellules montées en série, qui sont commandées pour transférer des charges d'une cellule à l'autre, dans laquelle, dans un substrat semi-conducteur (102) d'un premier type de conductivité (P) ayant un résistance faible, sont disposées une première région de diffusion (104') d'une première cellule d'un second type de conductivité (N$^+$), et, espacée de celle-ci, une seconde région de diffusion (104) d'une seconde cellule du second type de conductivité (N$^+$), et dans laquelle la surface du substrat semi-conducteur (102) est couverte d'une couche isolante (110, 106) sur laquelle se trouve, au-dessus de l'espace entre les régions de diffusion (104', 104), une électrode de porte (112), caractérisée en ce qu'elle comporte:

a) pour la première cellule, une région de drain agrandie avec implantation ionique (107) du second type de conductivité (N$^+$) qui est disposée entre les première (104') et seconde (104) régions de diffusion, connectée en série avec la seconde région de diffusion (104), et séparée de la première région de diffusion (104') par une région de canal (105), la région de drain agrandie (107) ayant une épaisseur inférieure à celle des régions de diffusion (104, 104'),

b) une couche isolante mince (110) sur la région de canal (105) et la région de drain agrandie avec implantation ionique (107),

c) une couce isolante épaisse (106, 106') sur les régions de diffusion (104, 104').

2. Structure selon la revendication 1, caractérisée en ce que la région de drain agrandie avec implantation ionique (107) a une épaisseur comprise entre 50 et 500 nm.

3. Structure selon l'une quelconque des revendications précédentes caractérisée en ce que la couche isolante mince (110) a une épaisseur uniforme sur la région de canal (105) et la région de drain agrandie avec implantation ionique (107).

4. Structure selon l'une quelconque des revendications précédentes caractérisée en ce que la concentration de dopage pour le substrat (102) est choisie de façon que sa résistance de surface soit comprise entre 1,3 ohm cm et 1,7 ohm cm.

5. Structure selon la revendication 4, caractérisée en ce que la profondeur de la jonction p-n des régions de diffusion (104, 104') par rapport à la surface du substrat (102) est supérieur à 1,5 $\mu$m.

6. Structure selon la revendication 5, caractérisée en ce que la dose de dopage du second type de conductivité dans la région de drain agrandie à implantation ionique (107) est d'environ 10$^{13}$ atomes/cm$^2$.

7. Structure selon l'une quelconque des revendications précédentes, caractérisée en ce que l'espace entre les parois latérales se faisant face des régions de diffusion (104, 104') est d'environ 13 $\mu$m et la longueur de la région de canal (105) d'environ 5 $\mu$m

8. Procédé pour fabriquer la structure de cellules semi-conductrices selon l'une quelconque des revendications 1 à 7, caractérisé en ce qu'elle nécessite les étapes suivantes:

a) croissance d'une première couche SiO$_2$ (130) sur un substrat de silicium d'un premier type de conductivité ayant une concentration de dopage relativement faible,

b) ouverture d'une pluralité de fenêtres de cellules (132, 134) espacées les unes des autres dans la première couche SiO$_2$ (130),

c) diffusion à l'intérieur d'une pluralité de régions d'un seconde type de conductivité ayant une concentration de dopage relativement élevée à travers les fenêtres cellulaires (132, 134), les fenêtres se refermant ensuite,

d) formation de fenêtres de porte dans la première couche SiO$_2$ entre paires adjacentes de régions de diffusion (104, 104'), les fenêtres de porte étant essentiellement alignées avec les bords se faisant face des régions de diffusion,

e) croissance d'une seconde couche SiO$_2$ dans les fenêtres de porte et sur la première couche SiO$_2$ pour former une couche isolante mince (110),

f) formation d'un masque d'implantation ionique (131) pour couvrir le bord de la première région de diffusion (104') faisant face à la seconde région de diffusion (104) et une partie de la région de porte avoisinante en laissant découverte une région de surface de la région de drain agrandie (107) dans chaque fenêtre de porte sur le côté de la seconde région de diffusion (104') faisant face à la première région de diffusion (104),

g) implantation ionique pour former une région de drain agrandie plate (107) du second type de conductivité de sorte qu'elle (107) soit connectée, de façon continue, avec le côté de la seconde région de diffusion (104) faisant face à la première région de diffusion (104'),

h) enlèvement du masque d'implémentation ionique (131) et formation des électrodes de porte (112) dans les fenêtres de porte correspondantes.

**FIG. 1a**

STAND
DER TECHNIK

**FIG. 1b**

**FIG. 1c**

INFORMATIONSFLUSS →

**FIG. 1d**

0 000 180

FIG. 2a

FIG. 2b

FIG. 2c

FIG. 2d

2

FIG. 3a

FIG. 3b

FIG. 3c

FIG. 3d

FIG. 3e

ΔV_T/ΔV_DS IN ABHGKT. VON EFFEKT. LÄNGE BEI IDS→0

12 Ωcm FLACHER ÜBERGANG

2 Ωcm TIEFER ÜBERGANG

1,5 Ωcm IMPLANTIERTER DRAIN-VERGRÖSSERUNGSBEREICH

EFFEKT. LÄNGE (μm)

**FIG. 4**

q SIGNAL 80—100 fC

q SIGNAL 40 fC

q SIGNAL (NULL) 6 fC

ÜBERTRAGUNGSVERLUST EINER IMPLANTIERTEN EIMERKETTENZELLE

EFFEKT. LÄNGE (μm)

**FIG. 5**